# EUROPEAN PATENT SPECIFICATION

(11) **EP 2 678 156 B1**
(45) Date of publication and mention of the grant of the patent: **04.10.2017**
(21) Application number: 12716772.4
(22) Date of filing: 24.02.2012
(51) Int. Cl.: B32B 15/08, B32B 15/14, H05K 1/03

(54) **ULTRATHIN LAMINATES**
ULTRADÜNNE LAMINATE
STRATIFIÉS ULTRAMINCES

(30) Priority: 24.02.2011 US 201161446458 P
(43) Date of publication of application: 01.01.2014
(73) Proprietor: Isola USA Corp., Chandler AZ 85226 (US)
(72) Inventor: SCHUMACHER, Johann, R., Gilbert AZ 85296 (US); SCHULTZ, Steven, M., Maricopa AZ 85139 (US); WILSON, Stanley, E., Chandler AZ 85248 (US); AMLA, Tarun, Chandler AZ 85248 (US)
(74) Representative: Müller-Boré & Partner Patentanwälte PartG mbB
(86) International application number: PCT/US2012/026582
(87) International publication number: WO 2012/116310

(56) References cited:
- EP-A1- 1 731 554

## Description

This invention concerns ultrathin copper clad laminates useful in manufacturing printed circuit boards comprising a thin woven glass sheet laminated between two opposing layers of copper foils as well as to methods for their manufacture.

As electronic devices become smaller, the components that make up the devices also grow smaller. At the same time the component performance demands increase. As the component sizes and electronic device sizes decrease, there is a need for similar decreases in the thickness of the circuit boards that carry the components. However, as circuit board laminates decrease in thickness, it becomes more difficult to keep the thickness of the board constant across its surface area. Additionally, the thinner circuit boards get, the more difficult it is to manufacture laminates used in printed circuit boards that consistently meet the electronic requirements of the circuit board industry. As a result, there is a continuing need for very thin circuit board laminate materials as well as for methods for making thin circuit board laminates consistently and reproducibly.

EP 1 731 554 A1 discloses a prepreg obtained by impregnating a resin composition comprising a resin with an imide structure and a thermosetting resin into a fiber base material with a thickness of 5-50 µm.

One aspect of this invention is a laminate comprising the combination of:
a base laminate including resin impregnated woven glass fabric sheet material having a first planar surface, a second planar surface, the woven glass fabric sheet having an original thickness of from 10 to 30 microns; and
at least one copper foil sheet that is adhered to a planar surface of the woven glass fabric sheet material by a cured resin wherein the base laminate thickness is from 25 to 45 microns [1.0 to 1.75 mils] and wherein the laminate has an average minimum dielectric thickness of no less than 19 microns [0.75 mils] and an average maximum dielectric thickness of no greater than 38 microns [1.5 mils], wherein the dielectric thickness refers to the range between the measured minimum and maximum thicknesses of the resin impregnated woven fabric material portion of the laminate and does not include the thickness of any copper layer associated with the laminate, and
wherein the base laminate thickness differs by no more than 20% when measured at the center and each of four corners of a 46 cm by 61 cm [18 inch by 24 inch] rectangular laminate sheet.

Specific embodiments of the laminate according to the present invention are characterized in dependent claims 2 to 10.

Another aspect of this invention is a method for manufacturing an ultrathin laminate material comprising the steps of:
placing a first copper foil sheet having a b-staged resin layer on at least one planar surface of the first copper foil sheet into contact with a first planar surface of a woven glass fabric sheet having a thickness of from 10 to 30 microns such that the planar surface of the woven glass fabric sheet contacts the resin coating to form a layup;
applying pressure and/or heat to the layup to cause the b-staged resin associated with the resin coated copper layer to penetrate into the woven glass fabric sheet; and
curing the b-staged resin for a time sufficient to cure the resin to form a laminate sheet having a dielectric thickness of from 19 microns [0.75 mils] to no greater than 38 microns [1.5 mils], wherein the dielectric thickness refers to the range between the measured minimum and maximum thicknesses of the resin impregnated woven fabric material portion of the laminate and does not include the thickness of any copper layer associated with the laminate, and
wherein the b-staged resin has a gel-time of 40-50 seconds and a viscosity of 15-25 Pascal seconds.

Specific embodiments of the method according to the present invention are characterized in dependent claims 12 to 14.
Figure 1 is a schematic of layers comprising laminates of this invention prior to lamination;
Figures 2A and 2B are several non-limiting embodiments of ultrathin laminates of this invention;
Figure 3 is a diagram showing some preferred aspects of a woven glass fabric material useful in the manufacture of ultrathin laminates of this invention;
Figure 4 is a schematic of a continuous process for preparing an ultrathin laminate of this invention; and
Figure 5 shows a method for measuring a minimum core dielectric thickness.

The present invention relates to ultrathin copper clad laminates that include a thin woven fiber layer associated with one or two layers of resin coated copper. The laminates include a woven fabric sheet layer having a first surface and a second surface and a thin copper sheet adhered to one or both of the first and second woven fabric sheet surfaces by a resin material. The total "base laminate thickness" - the thickness of the core resin impregnated woven fabric layer of the ultrathin copper clad laminate measured with a mechanical device such as a micrometer after removing the copper layer(s) from the laminate - will be from 1.0 to 1.75 mils (25-45 microns) and preferably from 1.3 to 1.75 mils (33-45 microns).

The ultrathin laminates of this invention are formed using one or two sheets of b-staged resin coated copper and a woven fabric sheet. Alternatively, the laminates are made using one or two sheet of copper and a resin impregnated woven fabric sheet. The laminates can be made using batch or continuous lamination processes. When b-staged resin coated copper sheets are used, the laminates of this invention are made by placing the resin side of each resin coated copper sheet against opposing planar surfaces of a thin fabric sheet to form a layup and thereafter applying pressure and/or heat to the layup. The pressure and/or heat applied to the layup causes the resin associated with the resin coated copper layer to soften and penetrate into the thin woven fabric sheet and, at the same time, the applied pressure and heat causes the resin to completely cure to form a thin c-staged copper clad laminate.

In an alternative process, the woven fabric sheet is thoroughly impregnated with a resin and the resin is partially cured to a prepreg or b-stage. Copper foil sheets are then applied to one or both planar surfaces of the partially cured resin impregnated woven fabric sheet to form a layup and the layup is fully cured by subjecting the layup to heat and/or pressure as above.

In order to aid in the impregnation of the fabric sheet with the resin, the fabric sheet can be pretreated or pre-wetted with a liquid such as a resin solvent or an uncured or partially cured epoxy resin solution. If a resin solution is used to pre-wet the fabric sheet, then the resin solution will usually have a solids content that is less than the solids content of the resin that is used to impregnate the fabric sheet. For example, the pre-wetting resin can have a solids content of from greater than 0% to 50% or more. In one embodiment, the fabric sheet is pre-wetted with an epoxy resin solution that includes from 5 wt. % to 25 wt. % solids and the remainder solvent.

The ultrathin laminates of this invention may be in the form of copper clad laminates including a copper foil layer attached to each planar surface of the ultrathin base laminate. Alternatively, one or both of the copper foil layers can be partially or totally etched or otherwise removed from one or both planar surfaces of the ultrathin base laminate to form an ultrathin dielectric laminate material layer.

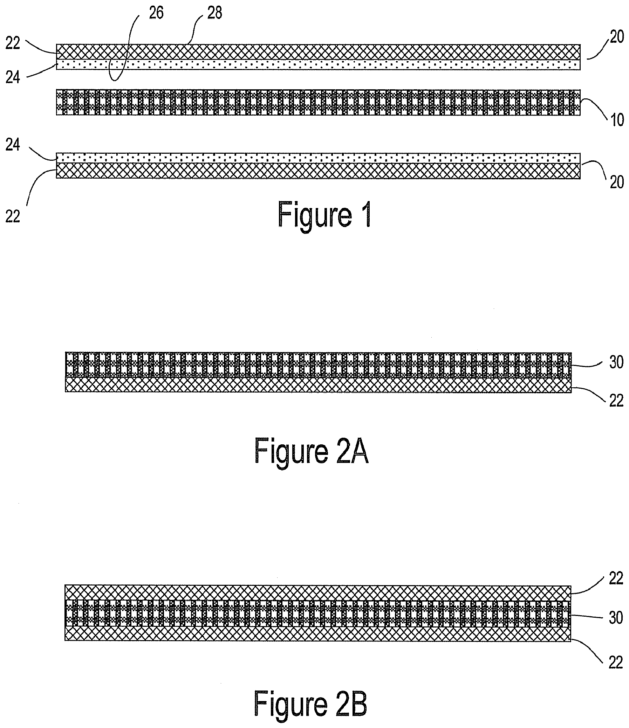

Referring now to Figure 1, there is shown an unassembled view of a thin copper clad laminate of this invention. The copper clad laminate comprises a thin fabric layer (10) that is sandwiched between two sheets of resin coated copper (20). Each resin coated copper sheet (20) includes a copper foil layer (22) and a resin layer (24) applied to a first planar surface (26) of copper foil layer (22). The second planar surface (28) of copper foil layer (22) may be coated or uncoated.

The unassembled laminated materials are then associated with each other to form a layup and thereafter subjected to heat and/or pressure sufficient to cause the resin to flow and impregnate fabric layer (10). Figures 2A and 2B show two embodiments of ultrathin laminates of this invention. Both embodiments include a base laminate layer (30) having a cured resin impregnated fabric material. The embodiments further include one or more copper foil layers (22) although both copper foil layers may be removed from the laminate by etching or by any other known method to form a useful ultrathin dielectric layer.

The fabric layer (10) may be any fabric material that has a thickness that is preferably less than 1 mil (25 microns). More preferably, fabric layer (10) will have a thickness that is less than 1 mil (25 microns) but greater than 0.5 mils (13 microns). Herein, the fabric layer is a woven glass cloth layer. Some examples of useful woven glass cloth materials include, but are not limited to 101, 104 and 106 glass cloth layers. Also useful are 1000 and 1017 woven glass cloth sheets or rolls such as those manufactured by Nittobo of Tokyo Japan. Properties of several useful woven glass fabric sheet materials are reported in Table 1 below.

**Table 1**

| **Application** | **Style** | **basis weight g/sqm** | **yarn (warp) counts/cm** | **yarn (weft) counts/cm** | **Nominal thickness Microns** | **Air permeability (cm³/m²/s)** |
|---|---|---|---|---|---|---|
| 1mil | 1000 | 12 | 33.5 | 33.5 | 14 | 300 |
| 1mil | 1017 | 13 | 37.4 | 37.4 | 14 | 230 |
| 2mil | 101 | 16.3 | 29.5 | 29.5 | 24 | |
| 2mil | 104 | 18.6 | 23.6 | 20.5 | 28 | |
| 2mil | 106 | 24.4 | 22 | 22 | 22 | |
| 2mil | 1037 | 24 | 27.6 | 28.3 | 25 | 65 |
| 2mil | 1039 | 26 | 29.1 | 30.3 | 25 | 51 |
| 2mil | 1027 | 20 | 29.1 | 29.1 | 20 | 83 |
| 2mil | 1029 | 22 | 33.5 | 33.5 | 20 | 54 |

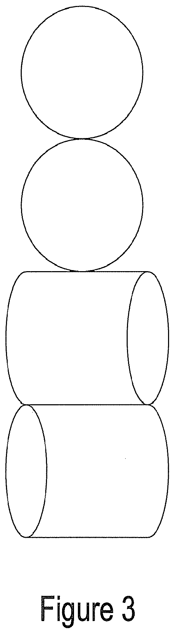

1017 woven glass fabric is the high density version of 1000 woven glass fabric in that it has additional filaments per unit of measure in the warp and weft directions. Both 1000 and 1017 woven glass fabrics offer greater mechanical stability to the laminate in comparison to 101 woven glass fabric. Also, both 1000 and 1017 woven glass fabrics are about 60% flatter than 101 woven glass fabric. Moreover, in both 1000 and 1017 woven glass fabrics, the yarns in warp and fill are spread apart so that a maximum of 2 filaments are stacked over and under as shown in Figure 3. This results in glass fabrics having an air permeability greater than 200 as shown in Table 1 above. This glass fabric property also results in a very thin fabric material layer in comparison to woven glass fabrics having more than 2 filaments stacked over and under. In addition we have found that glass fabrics woven from glass filaments having a diameter of from 3 microns to 5 microns and in particular 4 microns are particularly useful in manufacturing ultrathin laminates.

The resin coated copper foil sheets used in certain embodiments of the present invention may be any partially cured resin coated copper sheet materials used in the art. Herein, the resin coated copper foil is a b-staged resin coated copper foil sheet. In order to produce an ultrathin laminate sheet, it is preferred that the resin coated copper foil has a very thin partially cured resin layer and a very thin copper foil layer. Thus, in one embodiment, the resin layer of the resin coated copper can have a thickness that is less than 50 microns and greater than 5 microns. In another embodiment, the resin layer can have a thickness of 25 microns or less and 8 microns or greater. In still another embodiment, the resin layer can have a thickness of 15 microns.

The copper foil sheets used in manufacturing ultrathin laminates of this invention are preferably thin copper foil sheets or rolls such as a copper foil that is 2 oz or less and more preferably 1 oz copper or less. Generally the copper foil will have a thickness of from 15 to 40 microns. A narrower and useful copper foil thickness range is from 15 to 25 microns. In addition, the copper foil can be regular or reverse treated copper foil. In one embodiment, the copper foil surface that is associated with the resin layer or that is associated with the resin impregnated fabric sheet planar surface will have a roughness of from 3 to 5 microns. Alternatively, the copper can be applied in a very thin layer to a prepreg or b-staged base material or to a very thin prepreg or b-staged resin sheet by sputtering, by chemical vapor deposition or by any other process that is known in the art to be useful in applying a very thin layer of metal to a substrate.

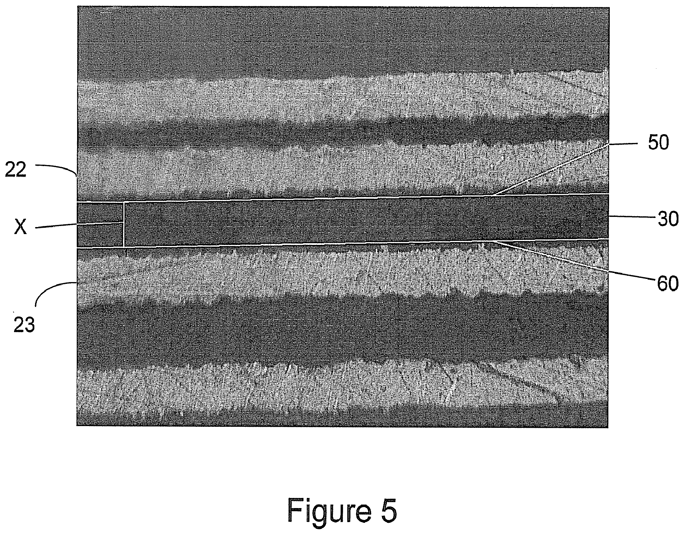

Ultrathin laminates of this invention will have an average (measured at 4 or more points of an 18 inch x 24 inch laminate sheet) "dielectric thickness" range of from 0.75 to 1.5 mils (19-38 microns) and preferably from 0.8 to 1.2 mils (20-30 microns). The term "dielectric thickness" refers to the range between the measured minimum and maximum thicknesses of the resin impregnated woven fabric material portion of the laminate and does not include the thickness of any copper layer associated with the laminate. The ultrathin laminate dielectric thickness ranges are measured by preparing a micro cross-section of the laminate and then measuring the minimum and maximum widths of the dielectric portion of the laminate under a microscope. The determination of the minimum dielectric thickness is explained with reference to Figure 5. The minimum dielectric thickness measurement is the distance (X) from the tip of the copper tooth or dendrite (50) that extends the furthest into the base laminate (30) from the copper layer (22) associated with one side of the laminate to the copper tooth or dendrite (60) that extends the furthest into the base laminate (30) from the copper layer (23) that is associated with the opposing side of the laminate. The maximum dielectric thickness is a measurement of the distance from the first copper plane to the opposing copper plane.

Another property of the ultrathin laminates of this invention that can be important is the laminate thickness distribution. Ideally the laminate should have the same thickness measured at any point over the surface area of the laminate. However, in practice, a uniform distribution is nearly impossible to achieve. The more the thickness deviates over the surface area of the laminate, the more likely it is that the laminate will not pass quality control testing such as Hipot testing, peel strength testing, etc. Therefore, the dimensional stability of the laminates of this invention will be such that the laminate "base thickness" as measured at the center and at the four corners of an 18 inch x 24 inch rectangular laminate material will vary no more than 20% and preferably no more than 10%.

The laminates of this invention employ resins to provide a dielectric barrier and/or to strengthen the fabric material layer. The term "resin" is used in the context of this application to refer generally to any curable resin composition that can be used now or in the future in the production of laminates used in printed circuit boards and other electronic applications. Most often, epoxy resins are used to make such laminates. The term "epoxy resin" refers generally to a curable composition of oxirane ring-containing compounds as described in C.A. May, Epoxy Resins, 2nd Edition, (New York & Basle: Marcel Dekker Inc.), 1988.

One or more epoxy resins are added to a resin composition in order to provide the desired basic mechanical and thermal properties of the cured resin and laminates made therefrom. Useful epoxy resins are those that are known to one of skill in the art to be useful in resin compositions useful for electronic composites and laminates.

Examples of epoxy resins include phenol types such as those based on the diglycidyl ether of bisphenol A ("Bis-A epoxy resin"), on polyglycidyl ethers of phenolformaldehyde novolac or cresol-formaldehyde novolac, on the triglycidyl ether of tris(p-hydroxyphenol)methane, or on the tetraglycidyl ether of tetraphenylethane, or types such as those based on tetraglycidylmethylenedianiline or on the triglycidyl ether of p-aminoglycol; cycloaliphatic types such as those based on 3,4-epoxycyclohexylmethyl-3,4-epoxycyclohexane carboxylate. The term "epoxy resin" also includes within its scope reaction products of compounds containing an excess of epoxy (for instance, of the aforementioned types) and aromatic dihydroxy compounds. These compounds may be halogen substituted.

The resin systems used in the resin coated copper foils may include additives and excipients known to those skilled in the art of formulating resin laminates such as flame retardants. However, it is preferred that the resins used in the laminates of this invention do not include any fillers such as talc, PTFE and so forth. Since fillers are sometimes added to resin systems as flow control agents, it can be useful to include a non-filler flow control agent to the resin before it is applied to a copper foil layer or used to impregnate the fabric cloth layer directly. One useful class of flow control agents are phenoxy resins which can be added to the resin systems used in this invention in amounts ranging from more than 0 wt.% to 2% on a solids basis.

Some examples of epoxy resins useful in the manufacture of the laminates of this invention are disclosed, for example, in U.S. patent nos. 5,464,658, 6,187,852, 6,509,414 and 6,322,885.

Especially useful epoxy resins will have a cured T_{g} of from 180 to 200°C. Moreover the resin and copper when combined and cured should result in an ultrathin laminate that has a peel strength of 4.5 lb./in or greater. In addition, a resin associated with a copper foil layer prior to the application of the resin coated copper foil layer to a fabric material layer is b-staged so that the gel time and viscosity of the resin are matched such that the resin penetrates the woven glass fabric and cures quickly during the laminate fabrication process. The resin is chosen and b-staged such that it has a gel time of from 40-50 seconds and a viscosity of from 15-25 Pascal seconds.

In one embodiment, a resin coated copper sheet useful in manufacturing ultrathin laminates of this invention can be made by applying an uncured or partially cured liquid resin to a copper foil sheet wherein the resin layer has a thickness of from 8 microns to 20 microns and more preferably a thickness of from 10 to 15 microns. When a resin coated copper sheet is used to make a laminate having a thickness of 1 mil or less, the copper foil used will be a 1 oz copper foil having a thickness of 18 microns and a surface roughness of 3 microns. The resin will be applied to one surface of the copper sheet at a thickness of 14 microns and partially cured to form a b-staged resin coated copper sheet.

The resins, fabrics and resin coated copper foil sheets described above can be used to make laminates of this invention in batch or in continuous processes. In an exemplary continuous process for manufacturing laminates of this invention, a continuous sheet in the form of each of copper, a resin prepreg and a thin fabric sheet are continuously unwound into a series of drive rolls to form a layered web of fabric, adjacent to the resin prepreg sheet which is adjacent to a copper foil sheet such that the prepreg sheet lies between the copper foil sheet and the fabric sheet. The web is then subjected to heat and pressure conditions for a time that is sufficient to cause the resin to migrate into the fabric material and to completely cure the resin. In the resulting laminate, the migration of the resin material into the fabric causes the thickness of the resin layer (the distance between the copper foil material and the fabric sheet material) to diminish and approach zero as combination layers discussed above transform from a web of three layers into a single laminate sheet. In an alternative to this method, a single prepreg resin sheet can be applied to one side of the fabric material layer and the combination sandwiched between two copper layers after which heat and/or pressure is applied to the layup to cause the resin material to flow and thoroughly impregnate the fabric layer and cause both copper foil layers to adhere to the base laminate.

In an alternative embodiment, the resin coated copper sheets can be made at the same time the laminate is being made by applying a thin coating of resin to two different continuously moving copper sheets, removing any excess resin from the sheets to control the resin thickness and then partially curing the resin under heat and/or pressure conditions to form a sheet of b-staged resin coated copper. The sheet(s) of b-staged resin coated copper can then be used directly in the laminate manufacturing process.

In still another embodiment, the fabric material - with or without prior pretreatment - can be continuously fed into a resin bath such that the fabric material becomes impregnated with the resin. The resin can be optionally partially cured at this stage in the process. Next, one or two copper foil layers can be associated with the first and/or second planar surface of the resin impregnated fabric sheet to form a web after which heat and/or pressure is applied to the web to fully cure the resin.

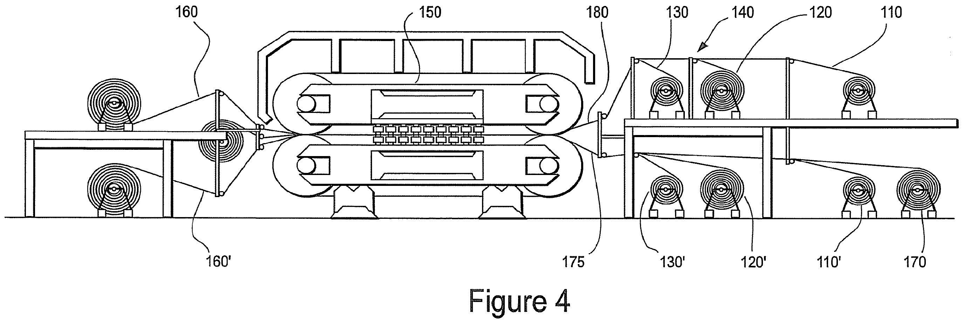

Another embodiment of a continuous process for manufacturing laminates of this invention is shown in Figure 4 in which continuous sheets in the form of each of a first resin coated copper t (110), fabric (120) and a second resin coated copper t (130) are continuously unwound into a series of drive rolls (140) to form a layered web - fabric, adjacent to the resin of the resin coated copper sheet which is adjacent to the release film. The web is then directed into a treating zone (150) at a constant rate and subjected to heat and pressure conditions for a time that are sufficient to cause the resin to migrate into the fabric material and to cure into a c-staged resin. In the resulting laminate (160) exits the treating zone (150) and is collected as a laminate roll (160). The process in Figure 4 includes two parallel feed and take up systems where parallel rolls of first resin coated copper (110'), fabric (120') and second resin coated copper (130') are combined to make a second web, the second web is directed to the treating zone (150) and the resulting laminate is collected in the form of a roll (160'). When two webs are directed into the treating zone (150) simultaneously, a spacer material such as a copper or aluminum metal sheet can be fed from a roll (170) and directed between the first web (175) and second web (180) to allow for the easy separation of the two thin laminate material layers when they exit the treating zone (150).

As noted above, the ultrathin laminates of this invention can be made by batch processes as well. In one batch process embodiment, a fabric sheet is applied to the resin layer of a b-staged resin coated copper foil sheet and a second b-staged resin coated copper foil sheet can then be applied - resin layer down - against the exposed fabric sheet. This process can be repeated one or more times to produce a stack including multiple laminates. The stack is then placed in a press that applies pressure and heat to the layup to cure the b-staged resin and to force the resin to flow into the fabric material as it cures. The pressure and heat are removed and the laminates are separated from one another.

The lamination methods and parameters used to manufacture the ultrathin laminates of this invention may vary widely, and are generally well known to the person of ordinary skill in the art. In a typical batch cure cycle, the stack is maintained at a pressure of 40 psi to 900 psi and under a vacuum of 30 in/Hg. The stack temperature is raised from 180°F to 375°F over a period of 20 minutes. The stack remains at a temperature of 375°F for 75 minutes after which the stack is cooled from a temperature of 375°F to a temperature to 75°F over a 20 minute period.

The following examples are illustrative of various aspects of this invention but do not serve to limit its scope.

### EXAMPLE 1

This example is a resin system useful for manufacturing ultrathin resin systems of the present invention. The resin system has the following recipe.

| **Component** | **Amount/kg** | **% Solids** |
|---|---|---|
| | | |
| **1.2-Phenylimidazole** | **0.115** | **0.09** |
| **2. brominated high Tg Epoxy Resin @ 85% Solid** | **46.030** | **58.24** |
| **3. Propylene glycol methyl ether** | **10.276** | **0.00** |
| **4. Epoxy Resin @ 70% Solid** | **9.863** | **10.28** |
| **5. Phenolic Resin @ 67,5% Solid** | **29.189** | **29.33** |
| **6. Phenoxyresin PKHH-30 @30% Solid** | **4.641** | **2.07** |
| | | |
| **SUM** | **101.147** | **100.00** |
| **Resin Solids: 66,42 %** | | |

The resin is prepared by adding propylene glycol methyl ether into a mixing vessel and then adding all remaining ingredients except for 2-phenylimidazole into the same mixing vessel and mixing the ingredients for 30 minutes. The 2-phenylimidazole is dissolved in propylene glycol methyl ether and then added to the mix. The mixture is homogenized for 30 minutes and the resin is ready to use.

### EXAMPLE 2

One method for making ultrathin laminates of this invention is by a batch lay up process using a hydraulic press. According to this method, an ultrathin fabric material is placed between two sheets of resin coated copper such that the resin coating contacts the fabric sheet material to form a layup. The layup is placed in a hydraulic press at a pressure of 15-20 bars and at a starting temperature of 110°C (230°F). The press temperature is increased to 190°C (375°F) at a rate of 5-7 degrees C per minute. The layup is held at 190°C for seventy minutes. The layup is then allowed to cool 30 minutes to room temperature.

Figures 2A is representative of a layup in which one copper layer (22) has been etched from the layup. The resin from the resin coated copper penetrates the fabric material to form a base laminate (30) during the layup process.

Several 7 inch x 8 inch lab scale layups were prepared by the above method using TRL8 and TRL15 resin coated copper sheets (having resin thickness of 8 or 15 microns) manufactured by Circuitfoil and 1000 and 1017 glass cloths. The layups were etched to remove the copper and after etching, the thicknesses of the layups were measured at each corner (upper right hand/upper left hand/lower right hand/lower left hand) and in the center of the layup. The results are reported in Table 2 below.

**TABLE 2**

| Glass Type | RCC Type | Thickness URHC | Thickness ULHC | Thickness LRHC | Thickness LLHC | thickness Center |
|---|---|---|---|---|---|---|
| 1000 | TRL8 | 1.0 mil | 1.1 mil | 1.2 mil | 1.0 mil | 1.0 mil |
| 1017 | TRL8 | 1.0 mil | 1.0 mil | 1.0 mil | 1.0 mil | 1.1 mil |
| 1000 | TRL15 | 1.9 mil | 1.9 mil | 1.9 mil | 2.0 mil | 2.0 mil |
| 1017 | TRL15 | 2.1 mil | 2.0 mil | 1.9 mil | 1.9 mil | 2.1 mil |

These results demonstrate good dimensional stability across the layup.

## Claims

1. A laminate comprising the combination of:
a base laminate including resin impregnated woven glass fabric sheet material having a first planar surface, a second planar surface, the woven glass fabric sheet having an original thickness of from 10 to 30 microns; and
at least one copper foil sheet that is adhered to a planar surface of the woven glass fabric sheet material by a cured resin wherein the base laminate thickness is from 25 to 45 microns [1.0 to 1.75 mils] and wherein the laminate has an average minimum dielectric thickness of no less than 19 microns [0.75 mils] and an average maximum dielectric thickness of no greater than 38 microns [1.5 mils], wherein the dielectric thickness refers to the range between the measured minimum and maximum thicknesses of the resin impregnated woven fabric material portion of the laminate and does not include the thickness of any copper layer associated with the laminate, and
wherein the base laminate thickness differs by no more than 20% when measured at the center and each of four corners of a 46 cm by 61 cm [18 inch by 24 inch] rectangular laminate sheet.

2. The laminate of claim 1 wherein the laminate has an average minimum dielectric thickness of no less than 20 microns [0.8 mils] and an average maximum dielectric thickness no greater than 30 microns [1.2 mils].

3. The laminate of claim 1 having a base laminate thickness of from 33 to 41 microns [1.3 to 1.6 mils].

4. The laminate of claim 1 wherein the copper foil has a thickness of from 15 to 40 microns or from 15 to 25 microns.

5. The laminate of claim 1 wherein the resin includes a flow control agent.

6. The laminate of claim 5 wherein the flow control agent is a phenoxy resin that is present in the resin in an amount ranging from more than 0 wt. % to 2 wt. % on a dry resin basis.

7. The laminate of claim 1 wherein the woven glass fabric has no more than 2 glass filaments stacked over and under wherein the glass filaments have a diameter of from 3 microns to 5 microns.

8. The laminate of claim 7 wherein the woven glass fabric has a filament diameter of 4 microns.

9. The laminate of claim 1 wherein the woven glass fabric sheet has a thickness of from 25 to 38 microns [1.0 to 1.5 mils].

10. The laminate of claim 1 wherein a copper foil sheet is adhered to each of the first and second base laminate planar surfaces by the cured resin wherein the laminate has an average minimum dielectric thickness of no less than 20 microns [0.8 mils] and an average maximum dielectric thickness of no greater than 30 microns [1.2 mils] wherein the woven glass fabric has no more than 2 glass filaments stacked over and under.

11. A method for manufacturing an ultrathin laminate material comprising the steps of:
placing a first copper foil sheet having a b-staged resin layer on at least one planar surface of the first copper foil sheet into contact with a first planar surface of a woven glass fabric sheet having a thickness of from 10 to 30 microns such that the planar surface of the woven glass fabric sheet contacts the resin coating to form a layup;
applying pressure and/or heat to the layup to cause the b-staged resin associated with the resin coated copper layer to penetrate into the woven glass fabric sheet; and
curing the b-staged resin for a time sufficient to cure the resin to form a laminate sheet having a dielectric thickness of from 19 microns [0.75 mils] to no greater than 38 microns [1.5 mils], wherein the dielectric thickness refers to the range between the measured minimum and maximum thicknesses of the resin impregnated woven fabric material portion of the laminate and does not include the thickness of any copper layer associated with the laminate, and
wherein the b-staged resin has a gel-time of 40-50 seconds and a viscosity of 15-25 Pascal seconds.

12. The method of claim 11 wherein a second copper sheet is placed into contact with a second planar surface of the woven glass fabric sheet before applying pressure and heat to the layup wherein the woven glass fabric sheet is impregnated with a resin or a layer of resin lies between the second copper foil sheet and the fabric sheet second planar surface or both.

13. The method of claim 11 wherein the laminate has an average minimum dielectric thickness of no less than 20 microns [0.80 mils] and an average maximum dielectric thickness of no greater than 30 microns [1.2 mils].

14. The method of claim 11 wherein the first copper foil sheet includes a b-staged resin layer having a thickness of from 10 to 25 microns.

## Patentansprüche

1. Laminat, umfassend die Kombination aus:
einem Basislaminat, einschließend ein harzimprägniertes Glasgewebebogenmaterial mit einer ersten planaren Oberfläche, einer zweiten planaren Oberfläche, wobei der Glasgewebebogen eine ursprüngliche Dicke von 10 bis 30 Mikrometer aufweist, und
mindestens einem Kupferfolienbogen, welcher an eine planare Oberfläche des Glasgewebebogenmaterials durch ein gehärtetes Harz anhaftet, wobei die Basislaminatdicke von 25 bis 45 Mikrometer [1,0 bis 1,75 Millizoll] beträgt und wobei das Laminat eine gemittelte minimale dielektrische Dicke von nicht weniger als 19 Mikrometer [0,75 Millizoll] und eine gemittelte maximale dielektrische Dicke von nicht größer als 38 Mikrometer [1,5 Millizoll] aufweist, wobei sich die dielektrische Dicke auf den Bereich zwischen den gemessenen minimalen und maximalen Dicken des harzimprägnierten Gewebematerialteils des Laminats bezieht und nicht die Dicke einer mit dem Laminat in Verbindung stehenden Kupferschicht einschließt und
wobei die Basislaminatdicke nicht mehr als 20% abweicht, gemessen in dem Zentrum und jeder der vier Ecken eines 46 cm mal 61 cm [18 Zoll mal 24 Zoll] rechteckigen Laminatbogens.

2. Laminat nach Anspruch 1, wobei das Laminat eine gemittelte minimale dielektrische Dicke von nicht weniger als 20 Mikrometer [0,8 Millizoll] und eine gemittelte maximale dielektrische Dicke von nicht größer als 30 Mikrometer [1,2 Millizoll] aufweist.

3. Laminat nach Anspruch 1, welches eine Basislaminatdicke von 33 bis 41 Mikrometer [1,3 bis 1,6 Millizoll] aufweist.

4. Laminat nach Anspruch 1, wobei die Kupferfolie eine Dicke von 15 bis 40 Mikrometer oder von 15 bis 25 Mikrometer aufweist.

5. Laminat nach Anspruch 1, wobei das Harz ein Fließregulierungsmittel einschließt.

6. Laminat nach Anspruch 5, wobei das Fließregulierungsmittel ein Phenoxyharz ist, welches in dem Harz in einer Menge im Bereich von mehr als 0 Gewichts-% bis 2 Gewichts-% auf einer Trockenharzbasis vorhanden ist.

7. Laminat nach Anspruch 1, wobei das Glasgewebe nicht mehr als 2 über- und untereinander gestapelte Glasfilamente aufweist, wobei die Glasfilamente einen Durchmesser von 3 Mikrometer bis 5 Mikrometer aufweisen.

8. Laminat nach Anspruch 7, wobei das Glasgewebe einen Filamentdurchmesser von 4 Mikrometer aufweist.

9. Laminat nach Anspruch 1, wobei der Glasgewebebogen eine Dicke von 25 bis 38 Mikrometer [1,0 bis 1,5 Millizoll] aufweist.

10. Laminat nach Anspruch 1, wobei ein Kupferfolienbogen an jede der ersten und zweiten planaren Oberflächen des Basislaminats durch das gehärtete Harz anhaftet, wobei das Laminat eine gemittelte minimale dielektrische Dicke von nicht weniger als 20 Mikrometer [0,8 Millizoll] und eine gemittelte maximale dielektrische Dicke von nicht größer als 30 Mikrometer [1,2 Millizoll] aufweist, wobei das Glasgewebe nicht mehr als 2 über- und untereinander gestapelte Glasfilamente aufweist.

11. Verfahren zur Herstellung eines ultradünnen Laminatmaterials, umfassend die Schritte:
Inkontaktbringen eines ersten Kupferfolienbogens, welcher eine Harzschicht im B-Zustand auf mindestens einer planaren Oberfläche des ersten Kupferfolienbogens aufweist, mit einer ersten planaren Oberfläche eines Glasgewebebogens, welcher eine Dicke von 10 bis 30 Mikrometer aufweist, so dass die planare Oberfläche des Glasgewebebogens die Harzbeschichtung zur Bildung einer Laminierung berührt,
Anwenden von Druck und/oder Wärme auf die Laminierung, um das mit der harzbeschichteten Kupferschicht in Verbindung stehende Harz im B-Zustand zum Eindringen in den Glasgewebebogen zu veranlassen, und
Härten des Harzes im B-Zustand für einen Zeitraum, der ausreicht, um das Harz zur Bildung eines Laminatbogens mit einer dielektrischen Dicke von 19 Mikrometer [0,75 Millizoll] bis nicht größer als 38 Mikrometer [1,5 Millizoll] zu härten, wobei sich die dielektrische Dicke auf den Bereich zwischen den gemessenen minimalen und maximalen Dicken des harzimprägnierten Gewebematerialteils des Laminats bezieht und nicht die Dicke einer mit dem Laminat in Verbindung stehenden Kupferschicht einschließt und
wobei das Harz im B-Zustand eine Gelierzeit von 40-50 Sekunden und eine Viskosität von 15-25 Pascalsekunden aufweist.

12. Verfahren nach Anspruch 11, wobei ein zweiter Kupferbogen mit einer zweiten planaren Oberfläche des Glasgewebebogens vor dem Anwenden von Druck und Wärme auf die Laminierung in Kontakt gebracht wird, wobei der Glasgewebebogen mit einem Harz imprägniert ist oder eine Harzschicht zwischen dem zweiten Kupferfolienbogen und der zweiten planaren Oberfläche des Gewebebogens liegt oder beidem.

13. Verfahren nach Anspruch 11, wobei das Laminat eine gemittelte minimale dielektrische Dicke von nicht weniger als 20 Mikrometer [0,80 Millizoll] und eine gemittelte maximale dielektrische Dicke von nicht größer als 30 Mikrometer [1,2 Millizoll] aufweist.

14. Verfahren nach Anspruch 11, wobei der erste Kupferfolienbogen eine Harzschicht im B-Zustand mit einer Dicke von 10 bis 25 Mikrometer einschließt.

## Revendications

1. Stratifié comprenant la combinaison de :
un stratifié de base incluant un matériau de plaque de tissu de verre tissé imprégné de résine ayant une première surface plane, une seconde surface plane, la plaque de tissu de verre tissé ayant une épaisseur originale de 10 à 30 microns ; et
au moins une plaque de feuille de cuivre qui est collée à une surface plane du matériau de plaque de tissu de verre tissé avec une résine durcie, dans lequel l'épaisseur de stratifié de base est de 25 à 45 microns [1,0 à 1,75 mils] et dans lequel le stratifié a une épaisseur diélectrique minimale moyenne d'au moins 19 microns [0,75 mils] et une épaisseur diélectrique maximale moyenne ne dépassant pas 38 microns [1,5 mils], dans lequel l'épaisseur diélectrique concerne la plage entre les épaisseurs minimale et maximale mesurées de la partie de matériau de tissu imprégné de résine du stratifié et n'inclut l'épaisseur d'aucune couche de cuivre associée au stratifié, et
dans lequel l'épaisseur de stratifié de base ne diffère pas de plus de 20 % lorsqu'elle est mesurée au centre et à chacun des quatre coins d'une plaque de stratifié rectangulaire de 46 cm par 61 cm [18 pouces par 24 pouces].

2. Stratifié selon la revendication 1, dans lequel le stratifié a une épaisseur diélectrique minimale moyenne d'au moins 20 microns [0,8 mils] et une épaisseur diélectrique maximale moyenne ne dépassant pas 30 microns [1,2 mils].

3. Stratifié selon la revendication 1, ayant une épaisseur de stratifié de base de 33 à 41 microns [1,3 à 1,6 mils].

4. Stratifié selon la revendication 1, dans lequel la feuille de cuivre a une épaisseur de 15 à 40 microns ou de 15 à 25 microns.

5. Stratifié selon la revendication 1, dans lequel la résine inclut un agent de régulation de débit.

6. Stratifié selon la revendication 5, dans lequel l'agent de régulation de débit est une résine phénoxy qui est présente dans la résine en une quantité allant de plus de 0 % en poids à 2 % en poids sur la base d'une résine sèche.

7. Stratifié selon la revendication 1, dans lequel le tissu de verre tissé n'a pas plus de 2 filaments de verre empilés au-dessus et en dessous, dans lequel les filaments de verre ont un diamètre de 3 microns à 5 microns.

8. Stratifié selon la revendication 7, dans lequel le tissu de verre tissé a un diamètre de filament de 4 microns.

9. Stratifié selon la revendication 1, dans lequel la plaque de tissu de verre tissé a une épaisseur de 25 à 38 microns [1,0 à 1,5 mils].

10. Stratifié selon la revendication 1, dans lequel une plaque de feuille de cuivre est collée à chacune des première et seconde surfaces planes de stratifié de base avec la résine durcie, dans lequel le stratifié a une épaisseur diélectrique minimale moyenne d'au moins 20 microns [0,8 mils] et une épaisseur diélectrique maximale moyenne ne dépassant pas 30 microns [1,2 mils], dans lequel le tissu de verre tissé n'a pas plus de 2 filaments de verre empilés au-dessus et au-dessous.

11. Procédé de fabrication d'un matériau de stratifié ultrafin comprenant les étapes de :
placement d'une première plaque de feuille de cuivre ayant une couche de résine d'étage b sur au moins une surface plane de la première plaque de feuille de cuivre en contact avec une première surface plane d'une plaque de tissu de verre tissé ayant une épaisseur de 10 à 30 microns de manière à ce que la surface plane de la plaque de tissu de verre tissé vienne en contact avec le revêtement de résine pour former un empilage ;
application de pression et/ou de chaleur à l'empilage pour amener la résine d'étage b associée à la couche de cuivre revêtue de résine à pénétrer dans la plaque de tissu de verre tissé ; et
durcissement de la résine d'étage b pendant un temps suffisant pour durcir la résine pour former une plaque de stratifié ayant une épaisseur diélectrique de 19 microns [0,75 mils] à pas plus de 38 microns [1,5 mils], dans lequel l'épaisseur diélectrique concerne la plage entre les épaisseurs minimale et maximale mesurées de la partie de matériau de tissu imprégné de résine du stratifié et n'inclut l'épaisseur d'aucune couche de cuivre associée au stratifié, et
dans lequel la résine d'étage b a un temps de gélification de 40 à 50 secondes et une viscosité de 15 à 25 pascals secondes.

12. Procédé selon la revendication 11, dans lequel une seconde plaque de cuivre est placée en contact avec une seconde surface plane de la plaque de tissu de verre tissé avant application de pression et de chaleur à l'empilage, dans lequel la plaque de tissu de verre tissé est imprégnée d'une résine ou une couche de résine se situe entre la seconde plaque de feuille de cuivre et la seconde surface plane de la plaque de tissu ou les deux.

13. Procédé selon la revendication 11, dans lequel le stratifié a une épaisseur diélectrique minimale moyenne de pas moins de 20 microns [0,80 mils] et une épaisseur diélectrique maximale moyenne de pas plus de 30 microns [1,2 mils].

14. Procédé selon la revendication 11, dans lequel la première plaque de feuille de cuivre inclut une couche de résine d'étage b ayant une épaisseur de 10 à 25 microns.
